# EUROPÄISCHE PATENTSCHRIFT

(11) **EP 1 358 626 B1**
(45) Veröffentlichungstag und Bekanntmachung des Hinweises auf die Patenterteilung: **28.11.2007**
(21) Anmeldenummer: 02711815.7
(22) Anmeldetag: 25.01.2002
(51) Int. Cl.: G06F 3/033, G06K 11/00, H03K 17/96

(54) **EINGABEVORRICHTUNG UND VERFAHREN ZUR EINGABE VON INFORMATIONEN IN EINE STEUEREINHEIT**
INPUT DEVICE AND METHOD FOR INPUTTING INFORMATION INTO A CONTROL UNIT
DISPOSITIF DE SAISIE ET PROCEDE DE SAISIE D'INFORMATIONS DANS UNE UNITE DE COMMANDE

(30) Priorität: 26.01.2001 DE 10103563
(43) Veröffentlichungstag der Anmeldung: 05.11.2003
(73) Patentinhaber: BSH Bosch und Siemens Hausgeräte GmbH, 81739 München (DE)
(72) Erfinder: REINKER, Bernward, 93128 Regenstauf (DE)
(86) Internationale Anmeldenummer: PCT/EP2002/000803
(87) Internationale Veröffentlichungsnummer: WO 2002/059829

(56) Entgegenhaltungen:
- WO-A-92/15083
- FR-A- 2 778 267
- US-A- 5 982 304

## Beschreibung

Die vorliegende Erfindung betrifft eine Eingabevorrichtung und ein Verfahren zur Eingabe von Informationen in eine Steuereinheit, insbesondere zur Einstellung einer zentralen Steuereinheit eines Hausgerätes

Es sind Vorrichtungen und dementsprechende Verfahren bekannt, bei denen die Eingabevorrichtung in Form eines Schalters ausgeführt ist. Sie sind weitgehend aus mechanischen Komponenten aufgebaut, so daß sie einen komplexen Aufbau aufweisen, Verschleiß unterliegen und auch in sonstiger Weise störungsanfällig sind. Insbesondere ist es bei überwiegend mechanisch aufgebauten Eingabevorrichtungen nicht möglich sicherzustellen, daß eine vorgenommene Einstellung auch angenommen bzw. mechanisch und/oder elektrisch geschaltet worden ist. Es ist also keine Rückmeldung über eine vorgenommene Auswahl zu erhalten, insbesondere bei einem Hausgerät, wie z. B. einer Waschmaschine,

Aus dem Bereich der CAD-Systeme sind verschiedene Ansätze für eine optische und/oder akustische Rückmeldung als Bestätigung einer gerade erfolgten Eingabe bekannt. Eine Signalisierung durch Licht ist aber stark vom Einfluß einer jeweiligen Umgebungsbeleuchtung abhängig, Eine Rückmeldung durch Farbwechsel setzt eine immer noch recht aufwendige separate Ansteuerung einer farbigen Anzeige oder das farbige Umschalten eine Leuchtdiode in einem Schalter, Taster etc. voraus. Die Wahmehmung eines Tonsignals ist wiederum in starkem Maße von einem Umgebungsgeräuschpegel abhängig.

Aus dem Dokument US 5,982,304 A ist ein piezoelektrisches Schaltelement bekannt, das für eine taktile Rückmeldung einer Betätigung ein piezoelektrisches Element enthält. Ein Stromkreis reagiert auf eine Betätigung des Schaltelements und stellt ein Signal zur Verfügung durch welches das piezoelektrische Element zu Vibrationen angeregt wird.

Aus dem Dokument WO 92/15083 A1 ist eine Folientastatur bekannt, bei der ein piezoelektrisches Element zur Erzeugung einer taktilen Rückantwort bei Betätigung der Folientastatur vorgesehen ist.

Aus dem Dokument FR 2 778 267 A1 ist eine Bedientaste für einen Aufzug bekannt, bei der zur Erzeugung einer taktilen Rückantwort bei Betätigung der Bedientaste eine elektrische Wicklung durch einen Wechselstrom zu Vibrationen angeregt wird.

Es ist die Aufgabe der vorliegenden Erfindung, ein verbessertes Verfahren und eine dementsprechende Vorrichtung zur Eingabe von Steuerungsinformationen, Parametern etc. insbesondere an einem Hausgerät zu schaffen.

Diese Aufgabe wird erfindungsgemäß durch eine Vorrichtung mit den Merkmalen von Anspruch 1 und ein Verfahren mit den Merkmalen von Anspruch 14 gelöst. Vorteilhafte Weiterbildungen der Erfindung sind Gegenstand der jeweiligen Unteransprüche.

Erfindungsgemäß weist eine Eingabevorrichtung zur Eingabe einer Information in eine Steuereinheit eine Einrichtung zur Detektion eines insbesondere durch einen Finger einer Bedienperson abgegebenen Signals auf. Das Signal des Fingers ist vorzugsweise ein leichter Druck, der auf die Detektionseinrichtung abgegeben wird und diese zur Abgabe eines elektrischen Signals veranlaßt. Die Detektionseinrichtung ist mit einer Verstärkungseinrichtung verbunden, die das elektrische Signal der Detektionseinrichtung verstärkt und an eine Einrichtung zur Wandlung und Ausgabe eines Rückmeldesignals in ein taktiles Signal weitergibt. Dabei ist das taktile Signal im wesentlichen nur im Bereich des Fingers an oder auf einer erfindungsgemäßen Eingabevorrichtung fühlbar. Damit ist sichergestellt, daß eine Bedienperson direkt nach dem Drücken einer erfindungsgemäßen Eingabevorrichtung eine spürbare Bestätigung erhält, die als Rückmeldung von der berührten Eingabevorrichtung abgegeben wird. Diese Rückmeldung stammt damit direkt von der berührten Eingabevorrichtung selber. Eine weitere Verbindung besteht natürlich zwischen der Verstärkungseinrichtung und einer Steuereinheit, in die eine Information eingegeben werden soll. Das Eingangssignal kann also direkt von einem menschlichen Finger abgegeben werden, aber auch ein Einsatz eines Stiftes etc. ist möglich. Ein Eingabegerät, wie z. B. ein vorstehend genannter Stift, ist aber erfindungsgemäß nicht erforderlich. Wohl ist das taktile Signal als Rückmeldung auch über einen Stift aufnehmbar und für einen Menschen, der den Stift in der Hand hält, gut fühlbar.

In einer Weiterbildung der Erfindung ist der Verstärkungseinrichtung eine Logik zur Aufbereitung und/oder Verarbeitung des elektrischen Signals vor- oder nachgeschaltet. Im einfachsten Fall besteht diese Logik aus einem Schwellwert-Glied, das ein eingehendes elektrisches Signal auf eine voreingestellte Sollstärke hin überprüft. Damit kann ein versehentliches und/oder zu leichtes Betätigen einer erfindungsgemäßen Eingabevorrichtung überwacht und ausgeschlossen werden. Eine nach dieser Ausführungsform ausgegebene Rückmeldung stammt somit nicht nur von der berührten Eingabevorrichtung selber, sondern sie ist die Reaktion einer nachgeschalteten elektrischen Logik. So wird vorteilhafterweise in einer erfindungsgemäßen Eingabevorrichtung eine Rückmeldung aus einer tiefer liegenden Systemschicht an eine Bedienperson übermittelt. Somit wird neben der reinen Betätigung einer bestimmten Eingabevorrichtung auch die Weitermeldung und/oder Verarbeitung einer Benutzer-Eingabe bestätigt und eine mögliche Fehlerquelle in einfacher Weise ausgeschlossen.

In einer vorteilhaften Ausführungsform der Erfindung ist die Einrichtung zur Detektion derart mit der Logik verbunden, daß die Logik während der Dauer einer Aktivierung der Einrichtung zur Wandlung und Ausgabe eines Rückmeldesignals von der Einrichtung zur Detektion kein Signal erhält. Damit ist ein gegenseitiges Aufschwingen durch eine Rückkopplung des taktischen Rückmeldesignals auf den Eingang der Detektionseinrichtung sehr effektiv ausgeschlossen.

Als Einrichtung zur Detektion und zur elektrischen Wandlung des mechanischen Signals des Fingers ist in einer Weiterbildung der Erfindung ein Sensor vorgesehen. Sensoren sind sehr kleine elektrische oder elektro-mechanische Elemente, die bei sehr geringem Aufwand in einer erfindungsgemäßen Eingabevorrichtung integrierbar sind. In einer Ausführungsform der Erfindung wird ein Sensor in Form eines Dehnungsmeßstreifens (DMS) eingesetzt. Ein DMS ist sehr dünn und kann relativ kleinflächig ausgebildet sein, so daß er im wesentlichen nur einen Berührungsbereich eines Fingers abdeckt, also die Fläche ungefähr einer Fingerkuppe.

Vorzugsweise wird als Einrichtung zur Wandlung des elektrisch erzeugten Quittungssignals oder eines Rückmeldesignals ein mechanischer Schwinger vorgesehen. Gegenüber einem beispielsweise akustischen Wandler deckt ein mechanischer Schwinger sehr direkt den Schwingungsbereich von ca. 20 bis etwa 200 Hz ab, in dem ein menschlicher Finger besonders empfindlich ist. Ein akustischer Wandler ist nur bedingt zur Abgabe von mechanischen Schwingungen in diesem Frequenzbereich geeignet. Der mechanische Schwinger ist besonders bevorzugt in Form eines piezoelektrischen Elementes ausgeführt.

Als Einrichtung zur Detektion des mechanischen Druck-Signals des Fingers ist vorzugsweise ein piezoelektrisches Element vorgesehen. Piezoelektrische Elemente bieten sich auch für diese Anwendung insbesondere aufgrund ihrer geringen Größe, eines niedrigen Gewichtes und ihrer wartungsfreien Langlebigkeit an. Zudem werden piezoelektrische Elemente als moderne Sinter- und/oder Keramikwerkstoffe mit maßgeschneiderten Eigenschaften immer besser verfügbar und preiswerter. In einer Ausführungsform der Erfindung werden die Einrichtung zur Detektion des mechanischen Signals des Fingers und die Einrichtung zur Wandlung des elektrisch erzeugten Quittungssignals durch piezoelektrische Elemente gebildet. In einer besonders bevorzugten Ausführungsform der Erfindung werden beide Einrichtungen durch ein gemeinsames piezoelektrisches Element gebildet, das einerseits ein Drucksignal detektiert und andererseits das Quittungssignal abgibt.

Vorzugsweise ist mindestens die Einrichtung zur Detektion des mechanischen Signals des Fingers mit einer Abdeckung verbunden. Dabei ist die Abdeckung in einem Bereich der Einrichtung zur Detektion des mechanischen Signals des Fingers und der Einrichtung zur Wandlung und Ausgabe des Quittungssignals mindestens teilweise flexibel. Ferner schließt die Abdeckung die Einrichtung zur Detektion des mechanischen Signals des Fingers und vorzugsweise auch die Einrichtung zur Wandlung des Quittungssignals gegenüber einer Umwelt ab. So ergibt sich insgesamt ein gegenüber Umwelteinflüssen, wie z. B. Staub, Flüssigkeiten oder Luftfeuchtigkeit, ein besonders sicherer Schutz, ohne daß die Funktionsfähigkeit beeinträchtigt werden würde. Es ergeben sich unter Einsatz einer erfindungsgemäßen Eingabevorrichtung ohne mechanische Stell- und Bedienteile, die nach außen hin Bedienblenden mit glatten Flächen aufweisen. Diese Eigenschaften sind insbesondere bei einem Einsatz in Haushaltsgeräten sehr vorteilhaft.

Die Form des Quittungssignals wird durch die Ausgabeeinrichtung und/oder durch die Logik bestimmt. Vorzugsweise finden als Quittungssignale in einer erfindungsgemäßen Vorrichtung transiente Schwingungen Einsatz. Das Abklingen eines Quittungssignals wird zeitlich auf ca. 1 bis etwa 100 ms festgelegt, um damit beispielsweise ein schnelles Freischalten der Detektionseinrichtung zur Eingabe weiterer Drucksignale ermöglichen zu können.

Vorzugsweise ist die Ausgabeeinrichtung und/oder die Logik zur Ausgabe von positiven und negative Quittungssignalen ausgebildet. Diese Signale können sich in angepaßter Weise hinsichtlich ihrer Intensität, Länge und einem Verlauf ihrer jeweiligen Transienten unterscheiden. Dabei werden zur Warnung bevorzugt Frequenzfenster mit besonders hoher taktiler Empfindlichkeit ausgewählt. Durch Versuchsreihen mit Personen können zudem besondere Transientenformen ausgewählt werden, die dann beispielsweise nicht nur ein impulshaftes Ansteigen und nachfolgend stetiges Abklingen umfassen.

Die Einrichtung zur Wandlung des Quittungssignals kann ferner auch zur Ausgabe von optischen und/oder akustischen Signalen ausgebildet sein. Durch diese Auswahlmöglichkeit können beim Einsatz einer erfindungsgemäßen Eingabevorrichtung mindestens zwei, vorzugsweise aber drei menschliche Sinne angesprochen werden: Hören, Sehen und Fühlen.

Eine erfindungsgemäße Eingabevorrichtung kann ohne Einschränkungen der Funktionalität in Form eines Spalten- oder Zeilenvektors oder aber einer Matrix durch Vervielfachung erweitert werden. Piezoelektrische Elemente weisen eine Oberflächen abmessung von ca. 5 x 5 mm aus, so daß als limitierender Faktor bei der Konzentration von erfindungsgemäße Eingabevorrichtungen beim Aufbau der genannten Anordnungen die Größe eines durchschnittlichen menschlichen Fingers ist. Diese Maß muß eingehalten werden, um eine klare Unterscheidung einzelnen Eingabevorrichtungen und deren unabhängige Auswahl per Fingerdruck sicherstellen zu können.

Nachfolgend werden einige Ausführungsbeispiele der Erfindung anhand der Zeichnung näher erläutert. In der Zeichnung zeigt:
- Figur 1:: eine Schnittdarstellung einer Schnittstelle zwischen einem Bediener und einer Eingabevorrichtung an einem Hausgerät und
- Figur 2:: eine perspektivische Darstellung eines Bedienfeldes mit weiteren Ausführungsformen von Eingabevorrichtungen.

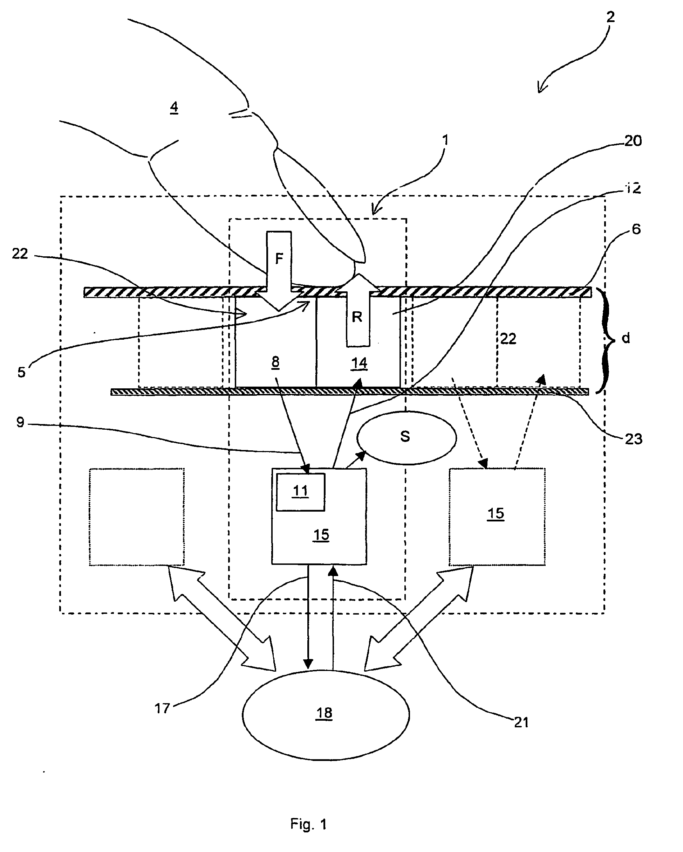

Figur 1 zeigt eine Schnittdarstellung einer Eingabevorrichtung 1 an einem Hausgerät 2 als Schnittstelle zwischen einer Bedienperson. Die Bedienperson drückt mit einem Finger 4 auf eine Stelle 5 einer Abdeckung 6. Ein von dem Finger 4 ausgeübte geringe Druck F wird in einer Einrichtung 8 detektiert. Das Finger-Druck-Signal F als mechanisches Signal wird in der Einrichtung 8 in ein elektrisches Signal 9 gewandelt und an einen Verstärker 11 weitergeleitet. Von hier aus wird ein verstärktes Signal aber nicht sofort als elektrisches Rückmelde- oder Quittierungssignal 12 an eine Einrichtung 14 zur Wandlung und Ausgabe eines Rückmeldesignals R ausgegeben. Es wird vielmehr an eine Logik 15 weitergeleitet. Die Logik 15 enthält einen Komparator oder ein Schwellwertglied, der das verstärkte Signal auf seine Größe hin untersucht und nur Signale ab einer bestimmten Stärke weiterleitet. Hierdurch wird eine Fehleingabe durch ein flüchtiges Anstoßen etc. unterbunden. Dabei kann die Logik 15 auch vor den Verstärker 11 verlagert werden, wenn das Signal 9 der Einrichtung 8 im Regelfall stark genug ist und/oder die Leitungswege kurz oder Störeinflüsse für ein schwaches elektrisches Signal 9 hinreichend gering sind.

Ist das Signal stärker als ein voreingestellter Grenzwert, so wird es von der Logik 15 durchgelassen und in Anpassung auf die Einrichtung 14 zur Wandlung und Ausgabe des Rückmeldesignals R aufbereitet. Ferner wird das Signal elektrisch aufbereitet und codiert als Programmiersignal 17 an eine zentrale Steuereinheit 18 als eigentliches Eingabesignal für die Steuerung des Hausgerätes 2 weitergeleitet.

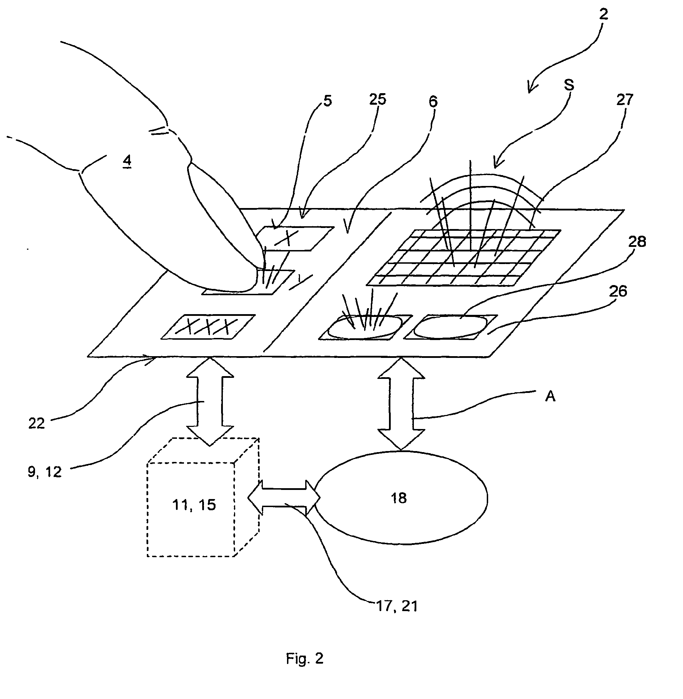

Die Einrichtung 14 zur Wandlung und Ausgabe des Rückmeldesignals R ist als mechanischer Schwinger 20 ausgebildet. Der mechanischer Schwinger 20 wird von der Logik 15 durch Anlegen eines Spannungspuls oder einer Wechselspannung mit einer transienten Komponente in vorbestimmter Weise zum Schwingen angeregt. In der Logik 15 kann so auch unter Auswertung eines Rückmeldesignals 21 von der zentralen Steuereinheit 18 zwischen einer positiven Quittierung und einer negativen Quittierung bzw. einer Störungsmeldung oder einem Warnsignal unterschieden werden. Durch die Ansteuerung des mechanischen Schwingers 20 durch die Logik 15 ist dieser Unterschied mit dem Finger 4 deutlich wahrnehmbar. Von der Logik aus werden aber auch sonstige Anzeigemittel S angesteuert, wie noch zu der Abbildung von Fig. 2 beschrieben werden wird.

In der Ausführungsform von Fig. 1 sind die Einrichtung 8 zur Detektion eines Finger-Druck-Signals F und die Einrichtung 14 zur Wandlung und Ausgabe eines Rückmeldesignals R in Form eines piezoelektrischen Elementes 22 ausgeführt. Derartige Elemente 22 weisen sehr geringe Oberflächenabmessungen und kleine Bauhöhen auf, so daß sich für einen vorgefertigten einstückigen Aufbau aus einer Glas- oder Polyacryl-Abdeckung 6 und einem relativ biegesteifen Träger 23 mit dazwischen angeordneten piezoelektrischen Elementen 22 eine gesamte Dicke d von weniger als 10 mm ergeben kann. Anschlüsse elektrischer Leitungen für die Signale 9, 12, 17, 18 werden auf dem Träger 23 geführt, auf dem auch die Logik 15 oder Teile der zentralen Steuereinheit 18 angeordnet sind können.

Das Drucksignal F erzeugt an dem piezoelektrischen Element 22 einen Spannungspuls, der aufbereitet und verstärkt wird. Das vorstehend beschriebene Verfahren läuft dann ab. Dabei ist zur Verhinderung einer Rückkopplung das elektrische Eingangs-Signal 9 an der Logik 15 und/oder dem Verstärker 11 für die Dauer deaktiviert bzw. der Eingang ist über die Dauer gesperrt, die das elektrische Rückmelde- oder Quittierungssignal 12 die Ausgabe des taktilen Rückmeldesignal R bewirkt. Nachfolgend wird der Eingang an der Logik 15 und/oder dem Verstärker 11 wieder freigeschaltet, wobei die Dauer der Sperrung in einem Bereich von ca. 1 bis einige 100 ms liegt.

In der Abbildung von Fig. 2 ist eine weitere Ausführungsform dargestellt. Als perspektivische Darstellung ist ein Bedienfeld für ein Hausgerät 2 mit weiteren Ausführungsformen von Eingabevorrichtungen 1 und sonstigen Anzeige- oder Ausgabemitteln S skizziert. Die Eingabevorrichtungen 1 sind dabei jeweils in der Form von Fig. 1 aufgebaut und als Spaltenvektor 25 einer Matrix so angeordnet, daß die einzelnen Eingabevorrichtungen 1 noch den jeweiligen Nachbarn unabhängig und sicher durch Drücken mit dem Finger 4 betätigt werden können. Die dargestellten Eingabevorrichtungen 1 sind an der Oberfläche der Abdeckung 6 direkt durch Bedrucken beschriftet oder durch eine daneben angeordnete Beschriftung hinsichtlich ihrer Funktion charakterisiert. Dabei bildet die Abdeckung 6 eine durchgehende und geschlossen ebene Oberfläche, die auch gut jedem Design eines Hausgerätes 2 angepaßt werden kann. In einer weitgehend geschlossenen Bauform einer Bedienleiste 26 ist der Spaltenvektor 25 mit drei Eingabevorrichtungen 1 einstückig integriert. Nebengeordnet sind als sonstige Anzeige- oder Ausgabemittel S ein akustischer Wandler oder Lautsprecher 27 und Leuchten 28. Diese sonstigen Anzeige- oder Ausgabemittel S werden durch Steuersignale A von der zentralen Steuereinheit 18 aus bedient.

Durch die Wahl der Ansteuerung jedes piezoelektrischen Elementes 22 von der Logik 15 und/oder dem Verstärker 11 ist eine gleichzeitige Ausgabe eines akustischen und taktilen Signals durch eine einzige geeignete Transiente möglich. So wird durch die mechanische Schwingung des piezoelektrischen Elementes 22 an der Stelle 5 die Abdeckung 6 zur Abstrahlung von Schallwellen in einem gut hörbaren Bereich von z. B. 1000 Hz angeregt, wobei die Schwingung mindestens bei ihrem Abklingen auf eine Frequenz von ca. 200 Hz auch sehr gut fühlbar ist. Neben dem Aufeinanderfolgen dieser Signalteile ist aber auch eine gleichzeitige Mischung und direkte Ausgabe durch ein und dasselbe piezoelektrische Element 22 möglich.

Die Abdeckung 6 ist mindestens teilweise flexibel ausgebildet. Sie ist beispielsweise beweglich oder elastisch verformbar und vorzugsweise als Membran ausgebildet.

## Patentansprüche

1. Eingabevorrichtung (1) zur Eingabe einer Information in eine Steuereinheit (18), insbesondere eine zentrale Steuereinheit eines Hausgerätes (2), insbesondere durch Betätigung mit einem Finger (4), wobei eine Einrichtung (8) zur Detektion eines durch einen Finger (4) einer Bedienperson abgegebenen Signals, vorzugsweise eines leichten Drucks, und zur Abgabe eines elektrischen Signals (9) vorgesehen ist, wobei die Einrichtung (8) mit einer Logik (15) zur Aufbereitung und/oder Verarbeitung des Signals (9) verbunden ist und wobei die Vorrichtung (1) eine Einrichtung (14) zur Wandlung und Ausgabe eines Rückmeldesignals (R) in ein taktiles Signal umfasst, das im wesentlichen nur im Bereich des Fingers (4) fühlbar ist, **dadurch gekennzeichnet, dass** die Einrichtung (8) zur Detektion derart mit der Logik (15) verbunden ist, dass die Logik (15) während der Dauer einer Aktivierung der Einrichtung (14) zur Wandlung und Ausgabe eines Rückmeldesignals (R) von der Einrichtung (8) zur Detektion kein Signal (9) erhält.

2. Eingabevorrichtung (1) nach Anspruch 1, **dadurch gekennzeichnet, dass** als Einrichtung (8) zur Detektion und zur elektrischen Wandlung des mechanischen Signals des Fingers (4) ein Sensor vorgesehen ist, insbesondere ein Dehnungsmessstreifen (DMS).

3. Eingabevorrichtung (1) nach Anspruch 1 oder 2, **dadurch gekennzeichnet, dass** als Einrichtung (14) zur Wandlung des elektrisch erzeugten Quittungssignals oder eines Rückmeldesignals (R) ein mechanischer Schwinger (20) vorgesehen ist.

4. Eingabevorrichtung (1) nach Anspruch 3, **dadurch gekennzeichnet, dass** der mechanische Schwinger (20) in Form eines piezoelektrischen Elementes (22) ausgeführt ist.

5. Eingabevorrichtung (1) nach einem der vorhergehenden Ansprüche, **dadurch gekennzeichnet, dass** als Einrichtung (8) zur Detektion des mechanischen Signals (F) des Fingers (4) ein piezoelektrisches Element (22) vorgesehen ist.

6. Eingabevorrichtung (1) nach einem der vorhergehenden Ansprüche, **dadurch gekennzeichnet, dass die** Einrichtung (8) zur Detektion des mechanischen Signals (F) des Fingers (4) und die Einrichtung (14) zur Wandlung des elektrisch erzeugten Quittungssignals durch ein gemeinsames piezoelektrisches Element (22) gebildet werden.

7. Eingabevorrichtung (1) nach einem der vorhergehenden Ansprüche, **dadurch gekennzeichnet, dass** die Einrichtung (8) zur Detektion des mechanischen Signals (F) des Fingers (4) mit einer Abdeckung (6) versehen und insbesondere damit verbunden ist.

8. Eingabevorrichtung (1) nach Anspruch 7, **dadurch gekennzeichnet, dass** die Abdeckung (6) in einem Bereich der Einrichtung (8) zur Detektion des mechanischen Signals (F) des Fingers (4) und der Einrichtung (14) zur Wandlung und Ausgabe des Quittungssignals (R) mindestens teilweise flexibel ist.

9. Eingabevorrichtung (1) nach Anspruch 7, **dadurch gekennzeichnet, dass** die Abdeckung (6) beweglich oder elastisch verformbar ist.

10. Eingabevorrichtung (1) nach Anspruch 7, **dadurch gekennzeichnet, dass** die Abdeckung (6) als Membran ausgebildet ist.

11. Eingabevorrichtung (1) nach einem der Ansprüche 7 bis 10, **dadurch gekennzeichnet, dass** die Abdeckung (6) die Einrichtung (8) zur Detektion des mechanischen Signals (F) des Fingers (4) und vorzugsweise auch die Einrichtung (14) zur Wandlung des Quittungssignals (R) gegenüber einer Umwelt abschließt.

12. Eingabevorrichtung (1) nach einem der vorhergehenden Ansprüche, **dadurch gekennzeichnet, dass** die Logik (15) in Abhängigkeit vom Zustand der Vorrichtung (1) zur Ausgabe von positiven und negative Quittungssignalen (R) ausgebildet ist.

13. Eingabevorrichtung (1) nach einem der vorhergehenden Ansprüche, **dadurch gekennzeichnet, dass** die Einrichtung (14) zur Wandlung des Quittungssignals (R) und auch zur Ausgabe von optischen und/oder akustischen Signalen ausgebildet ist, insbesondere über akustische Wandler (27) oder Leuchten (28) etc..

14. Verfahren zur Eingabe von Informationen von Hand in eine Steuereinheit (18), insbesondere zum Einstellen einer zentralen Steuereinheit eines Hausgerätes (2), wobei durch Drücken einer Stelle (5) ein elektrisches Signal (8) erzeugt, in einer Logik (15) verarbeitet und als Quittung durch Vibration im wesentlichen nur an der Stelle (5) selber wahrnehmbar gemacht wird, **dadurch gekennzeichnet, dass** ein Eingang der Logik (15) für die Dauer eines Rückmeldesignals (R) für das elektrische Signal (8) gesperrt wird.

15. Verfahren nach Anspruch 14, **dadurch gekennzeichnet, dass** das elektrische Signal (8) durch einen Drucksensor erzeugt wird, insbesondere durch ein piezoelektrisches Element (22).

16. Verfahren nach Anspruch 14 oder 15, **dadurch gekennzeichnet, dass** ein Quittungs- oder ein Rückmeldesignal (R) durch einen mechanischen Schwinger (20) erzeugt wird, insbesondere durch ein piezoelektrisches Element.

17. Verfahren nach einem der Ansprüche 14 bis 16, **dadurch gekennzeichnet, dass** das elektrische Signal (8) in der Logik (15) verstärkt wird.

18. Verfahren nach einem der Ansprüche 14 bis 17, **dadurch gekennzeichnet, dass** die Logik (15) von der zentralen Steuereinheit (18) ein elektrisches Rückmeldesignal (21) mit einer Unterscheidung in verschiedene Quittungs- und/oder Warnsignale (18) zur Abgabe über den mechanischen Schwinger (20) erhält.

19. Verfahren nach einem der Ansprüche 14 bis 18, **dadurch gekennzeichnet, dass** durch die Logik (15) zur Reizung mindestens zweier menschlicher Sinne die Aussendung taktiler und akustischer und/oder optischer Signale veranlasst wird.

20. Verfahren nach einem der Ansprüche 14 bis 19, **dadurch gekennzeichnet, dass** zur Aussendung optischer oder sichtbar Signale das Licht und/oder die Beleuchtung von Teilen einer Bedienungsblende (26) und/oder eine Farbe innerhalb der Bedienungsblende (26) geändert wird, vorzugsweise im Bereich der Stelle (5), in der der Finger (4) oder ein Stift etc. ein Drucksignal (F) aussendet.

## Claims

1. Input device (1) for the input of information into a control unit (18), particularly a central control unit of a domestic appliance (2), particularly by actuation by a finger (4), wherein equipment (8) for detection of a signal delivered by a finger (4) of an operator, preferably a light pressure, and for issue of an electrical signal (9) is provided, wherein the equipment (8) is connected with a logic system (15) for preparation and/or processing the signal (9) and wherein the device (1) comprises equipment (14) for conversion, and output, of an feedback signal (R) into a tactile signal which can be sensed substantially only in the region of the finger (4), **characterised in that** the equipment (8) for detection is connected with the logic system (15) in such a manner that the logic system (15) during the duration of activation of equipment (14) for conversion and output of an feedback signal (R) does not receive any signal (9) from the equipment (8) for detection.

2. Input device (1) according to claim 1, **characterised in that** a sensor, particularly a strain gauge (DMS), is provided as equipment (8) for detection and for electrical conversion of the mechanical signals of the finger (4).

3. Input device (1) according to claim 1 or 2, **characterised in that** a mechanical oscillator (20) is provided as equipment (14) for conversion of the electrically generated acknowledgement signal or a feedback signal (R).

4. Input device (1) according to claim 3, **characterised in that** the mechanical oscillator (2) is constructed in the form of a piezoelectric element (22).

5. Input device (1) according to one of the preceding claims, **characterised in that** a piezoelectric element (22) is provided as for equipment (8) for detection of the mechanical signal (F) of the finger (4).

6. Input device (1) according to one of the preceding claims, **characterised in that** the equipment (8) for detection of the mechanical signal (F) of the finger (4) and the equipment (14) for conversion of the electrically generated acknowledgement signal are formed by a common piezoelectric element (22).

7. Input device (1) according to one of the preceding claims, **characterised in that** the equipment (8) for detection of the mechanical signal (F) of the finger (4) is provided with a cover (6) and, in particular, connected therewith.

8. Input device (1) according to claim 7, **characterised in that** the cover (6) is flexible at least in part in a region of the equipment (8) for detection of the mechanical signal (F) of the finger (4) and of the equipment (14) for conversion and output of the acknowledgement signal (R).

9. Input device (1) according to claim 7, **characterised in that** the cover (6) is movable or resiliently deformable.

10. Input device (1) according to claim 7, **characterised in that** the cover (6) is constructed as a membrane.

11. Input device (1) according to one of claims 7 to 10, **characterised in that** the cover (6) seals the equipment (8) for detection of the mechanical signal (F) of the finger (4), and preferably also the equipment (14) for conversion of the acknowledgement signal (R), relative to an environment.

12. Input device (1) according to one of the preceding claims, **characterised in that** the logic system (15) is constructed for output of positive and negative acknowledgement signals (R) in dependence on the state of the device (1).

13. Input device (1) according to one of the preceding claims, **characterised in that** the equipment (14) is constructed for conversion of the acknowledgement signal (R) and also for output of optical and/or acoustic signals, particularly by way of acoustic converters (27) or lights (28), etc.

14. Method for input of items of information by hand into a control unit (18); particularly for setting a central control unit of a domestic appliance (2), wherein an electrical signal (8) is generated by pressing a position (5), is processed in a logic system (15) and is made perceptible as an acknowledgement by vibration substantially only at the position (5) itself, **characterised in that** an input of the logic system (15) for the electrical signal (8) is blocked for the duration of a feedback signal (R).

15. Method according to claim 14, **characterised in that** the electrical signal (8) is generated by a pressure sensor, particularly by a piezoelectric element (22).

16. Method according to claim 14 or 15, **characterised in that** an acknowledgement signal or a feedback signal (R) is generated by a mechanical oscillator (20), particularly by a piezoelectric element.

17. Method according to one of claims 14 to 16, **characterised in that** the electrical signal (8) is amplified in the logic system (15).

18. Method according to one of claims 14 to 17, **characterised in that** the logic system (15) obtains from the central control unit (18) an electrical feedback signal (21) with a differentiation into different acknowledgement and/or warning signals (18) for output by way of the mechanical oscillator (20).

19. Method according to one of claims 14 to 18, **characterised in that** the emission of tactile and acoustic and/or optical signals is caused by the logic system (15) for stimulation of at least two human senses.

20. Method according to one of claims 14 to 19, **characterised in that** for emission of optical or visible signals the light and/or the illumination of parts of a control panel (26) and/or a colour within the control panel (26) is or are changed, preferably in the region of the position (5) in which the finger (4) or a pencil, etc., transmits a pressure signal (F).

## Revendications

1. Dispositif de saisie (1) pour entrer une information dans une unité de commande (18), notamment dans une unité de commande centrale d'un appareil électroménager (2), notamment par actionnement avec un doigt (4), un dispositif (8) de détection d'un signal donné au moyen d'un doigt (4) d'une personne de commande, de préférence au moyen d'une légère pression, et de sortie d'un signal électrique (9) étant prévu, le dispositif (8) étant connecté à une logique (15) pour préparer et/ou traiter le signal (9) et le dispositif (1) comprenant un équipement (14) pour convertir et sortir un signal d'information en retour (R) en un signal tactile qui est essentiellement perceptible seulement dans la partie du doigt (4), **caractérisé en ce que** le dispositif (8) de détection est connecté de telle manière à la logique (15) que la logique (15), pendant la durée d'une activation de l'équipement (14) de conversion et de sortie d'un signal d'information en retour (R), n'obtient aucun signal (9) du dispositif (8) de détection.

2. Dispositif de saisie (1) selon la revendication 1, **caractérisé en ce qu'**un capteur, notamment une jauge de contrainte (DMS), est prévu en tant que dispositif (8) de détection et de conversion électrique du signal mécanique du doigt (4).

3. Dispositif de saisie (1) selon la revendication 1 ou 2, **caractérisé en ce qu'**un vibrateur (20) mécanique est prévu en tant qu'équipement (14) de conversion du signal d'accusé de réception généré électriquement ou d'un signal d'information en retour (R).

4. Dispositif de saisie (1) selon la revendication 3, **caractérisé en ce que** le vibrateur (20) mécanique est exécuté sous forme d'un élément piézoélectrique (22).

5. Dispositif de saisie (1) selon l'une quelconque des revendications précédentes, **caractérisé en ce qu'**un élément piézoélectrique (22) est prévu en tant que dispositif (8) de détection du signal mécanique (F) du doigt (4).

6. Dispositif de saisie (1) selon l'une quelconque des revendications précédentes, **caractérisé en ce que** le dispositif (8) de détection du signal mécanique (F) du doigt (4) et l'équipement (14) de conversion du signal d'accusé de réception généré électriquement sont formés par un élément piézoélectrique (22) commun.

7. Dispositif de saisie (1) selon l'une quelconque des revendications précédentes, **caractérisé en ce que** le dispositif (8) de détection du signal mécanique (F) du doigt (4) est muni d'un recouvrement (6) et y est notamment raccordé.

8. Dispositif de saisie (1) selon la revendication 7, **caractérisé en ce que** le recouvrement (6) est flexible, au moins en partie, dans une zone du dispositif (8) de détection du signal mécanique (F) du doigt (4) et de l'équipement (14) de conversion et de sortie du signal d'accusé de réception (R).

9. Dispositif de saisie (1) selon la revendication 7, **caractérisé en ce que** le recouvrement (6) est mobile ou déformable élastiquement.

10. Dispositif de saisie (1) selon la revendication 7, **caractérisé en ce que** le recouvrement (6) est exécuté en tant que membrane.

11. Dispositif de saisie (1) selon l'une quelconque des revendications 7 à 10, **caractérisé en ce que** le recouvrement (6) obture, par rapport à un environnement, le dispositif (8) de détection du signal mécanique (F) du doigt (4) et de préférence également l'équipement (14) de conversion du signal d'accusé de réception (R).

12. Dispositif de saisie (1) selon l'une quelconque des revendications précédentes, **caractérisé en ce que** la logique (15) est exécutée en fonction de l'état du dispositif (1) de sortie de signaux positifs et négatifs d'accusé de réception (R).

13. Dispositif de saisie (1) selon l'une quelconque des revendications précédentes, **caractérisé en ce que** l'équipement (14) est exécuté pour la conversion du signal d'accusé de réception (R) et également pour la sortie de signaux optiques et/ou acoustiques, notamment par l'intermédiaire de convertisseurs acoustiques (27) ou de lampes (28), etc..

14. Procédé pour la saisie d'informations à la main dans une unité de commande (18), notamment pour le paramétrage d'une unité de commande centrale d'un appareil électroménager (2), un signal électrique (8) étant généré en appuyant sur un endroit (5), étant traité dans une logique (15) et étant rendu perceptible en tant qu'accusé de réception par vibration essentiellement seulement à l'endroit (5) même, **caractérisé en ce qu'**une entrée de la logique (15) est verrouillée pour le signal électrique (8) pour la durée d'un signal d'information en retour (R).

15. Procédé selon la revendication 14, **caractérisé en ce que** le signal électrique (8) est généré au moyen d'un capteur de pression, notamment au moyen d'un élément piézoélectrique (22).

16. Procédé selon la revendication 14 ou 15, **caractérisé en ce qu'**un signal d'accusé de réception ou un signal d'information en retour (R) est généré au moyen d'un vibrateur mécanique (20), notamment au moyen d'un élément piézoélectrique.

17. Procédé selon l'une quelconque des revendications 14 à 16, **caractérisé en ce que** le signal électrique (8) est amplifié dans la logique (15).

18. Procédé selon l'une quelconque des revendications 14 à 17, **caractérisé en ce que** la logique (15) obtient de l'unité de commande centrale (18) un signal électrique d'information en retour (21) avec une différenciation en différents signaux d'accusé de réception et/ou signaux d'avertissement (18) pour leur sortie par l'intermédiaire du vibrateur mécanique (20).

19. Procédé selon l'une quelconque des revendications 14 à 18, **caractérisé en ce que** l'émission de signaux tactiles et acoustiques et/ou optiques est causée par la logique (15) pour l'excitation d'au moins deux sens d'êtres humains.

20. Procédé selon l'une quelconque des revendications 14 à 19, **caractérisé en ce que** pour l'émission de signaux optiques ou visibles, la lumière et/ou l'éclairage de parties d'un panneau de commande (26) et/ou une couleur à l'intérieur du panneau de commande (26) sont modifiés, de préférence dans la zone de l'endroit (5), dans lequel le doigt (4) ou un crayon, etc., émet un signal par pression (F).
